# EUROPÄISCHE PATENTSCHRIFT

(11) **EP 1 342 266 B1**
(45) Veröffentlichungstag und Bekanntmachung des Hinweises auf die Patenterteilung: **30.07.2008**
(21) Anmeldenummer: 01986854.6
(22) Anmeldetag: 06.12.2001
(51) Int. Cl.: H01L 21/8249

(54) **VERFAHREN ZUR HERSTELLUNG VON SCHNELLEN VERTIKALEN NPN-BIPOLARTRANSISTOREN UND KOMPLEMENTÄREN MOS-TRANSISTOREN AUF EINEM CHIP**
METHOD FOR PRODUCING HIGH-SPEED VERTICAL NPN BIPOLAR TRANSISTORS AND COMPLEMENTARY MOS TRANSISTORS ON A CHIP
PROCEDE DE PRODUCTION DE TRANSISTORS BIPOLAIRES NPN VERTICAUX RAPIDES ET DE TRANSISTORS MOS COMPLEMENTAIRES SUR UNE PUCE

(30) Priorität: 08.12.2000 DE 10061199
(43) Veröffentlichungstag der Anmeldung: 10.09.2003
(73) Patentinhaber: IHP GmbH-Innovations for High Performance Microelectronics/Institut für innovative Mikroelektronik, 15236 Frankfurt an der Oder (DE)
(72) Erfinder: KNOLL, Dieter, 15230 Frankfurt (Oder) (DE); HEINEMANN, Bernd, 15234 Frankfurt (Oder) (DE)
(74) Vertreter: Eckey, Ludger
(86) Internationale Anmeldenummer: PCT/EP2001/014319
(87) Internationale Veröffentlichungsnummer: WO 2002/047160

(56) Entgegenhaltungen:
- US-A- 6 066 521
- OSTEN H J ET AL: "Carbon doped SiGe heterojunction bipolar transistor module suitable for integration in a deep submicron CMOS process" 2000 ASIA-PACIFIC MICROWAVE CONFERENCE. PROCEEDINGS (CAT. NO.00TH8522), PROCEEDINGS OF 2000 ASIA-PACIFIC MICROWAVE CONFERENCE, SYDNEY, NSW, AUSTRALIA, 3-6 DEC. 2000, Seiten 757-762, XP001077743 2000, Piscataway, NJ, USA, IEEE, USA ISBN: 0-7803-6435-X
- PATENT ABSTRACTS OF JAPAN vol. 1998, no. 11, 30. September 1998 (1998-09-30) -& JP 10 178117 A (SONY CORP), 30. Juni 1998 (1998-06-30)
- EHWALD K E ET AL: "Modular integration of high-performance SiGe:C HBTs in a deep submicron, epi-free CMOS process" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5. Dezember 1999 (1999-12-05), Seiten 561-564, XP010372172 ISBN: 0-7803-5410-9
- ST ONGE S A ET AL: "A 0.24 /spl mu/m SiGe BiCMOS mixed-signal RF production technology featuring a 47 GHz ft HBT and 0.18 /spl mu/m Lett CMOS" BIPOLAR/BICMOS CIRCUITS AND TECHNOLOGY MEETING, 1999. PROCEEDINGS OF THE 1999 MINNEAPOLIS, MN, USA 26-28 SEPT. 1999, PISCATAWAY, NJ, USA,IEEE, US, 26. September 1999 (1999-09-26), Seiten 117-120, XP010359517 ISBN: 0-7803-5712-4
- DUNN J ET AL: "Trends in silicon germanium BiCMOS integration and reliability" 2000 IEEE INTERNATIONAL RELIABILITY PHYSICS SYMPOSIUM PROCEEDINGS. 38TH ANNUAL (CAT. NO.00CH37059), 2000 IEEE INTERNATIONAL RELIABILITY PHYSICS SYMPOSIUM PROCEEDINGS. 38TH ANNUAL, SAN JOSE, CA, USA, 10-13 APRIL 2000, Seiten 237-242, XP001077899 2000, Piscataway, NJ, USA, IEEE, USA ISBN: 0-7803-5860-0
- KNOLL D ET AL: "HBT before CMOS, a new modular SiGe BiCMOS integration scheme" INTERNATIONAL ELECTRON DEVICES MEETING. TECHNICAL DIGEST (CAT. NO.01CH37224), INTERNATIONAL ELECTRON DEVICES MEETING. TECHNICAL DIGEST, WASHINGTON, DC, USA, 2-5 DEC. 2001, Seiten 22.2.1-4, XP001074775 2001, Piscataway, NJ, USA, IEEE, USA ISBN: 0-7803-7050-3

## Beschreibung

Die Erfindung betrifft ein Verfahren zur Herstellung von schnellen vertikalen npn-Bipolartransistoren und komplementären MOS-Transistoren auf einem Chip gemäß Anspruch 1.

BiCMOS-Technologien werden zur Herstellung von integrierten Schaltungen oder Schaltungsblöcken eingesetzt, die sowohl MOS-Transistoren mit p- und n-Kanal als auch Bipolartransistoren enthalten. Derartige integrierte Schaltungen sind beispielsweise aus der US 6066521 un der JP10178117 bekannt. Moderne BiCMOS-Technologien zielen speziell darauf ab, Schaltungsblöcke mit sehr schnellen Bipolartransistoren und höchstintegrierte CMOS-Logik auf einem Chip zu vereinen, um leistungsfähige technologische Plattformen für die drahtlose und die Lichtleiter-basierte Telekommunikation zu erhalten. Auf Grund des immensen Aufwandes für die Entwicklung und Qualifikation einer höchstintegrierten CMOS-Technologie ist die modulare Integration von Bipolartransistoren in eine qualifizierte CMOS-Technologie der kostengünstigste Weg zur Realisierung einer solchen modernen BiCMOS-Technologie. Modulare Integration bedeutet dabei, dass der Einfluss der zusätzlichen Verfahrensschritte, die zur Herstellung der Bipolartransistoren benötigt werden, auf die Parameter und Ausbeute der CMOS-Transistoren so gering gehalten wird, dass die Schaltungsbibliotheken der CMOS-Technologie auch für die daraus abgeleitete BiCMOS-Technologie nutzbar sind; siehe zum Beispiel H.J. Osten et al, "Carbon doped SiGe Heterojunction Bipolar Transistor Module suitable for integration in a deep submicron CMOS process", Asia Pacific Microwave conf. 2000, pg.757.762. Bestes Hochfrequenzverhalten von Si-basierten Bipolartransistoren wird derzeit mit SiGe-Hetero-Bipolartransistoren (SiGe-HBT) erreicht. Deshalb werden SiGe-HBT auch für Hochleistungs-BiCMOS-Technologien verwendet, wie beispielsweise in G. Freeman und Mitautoren: "A 0.18 µm 90 GHz fT SiGe HBT BiCMOS, ASIC-Compatible, Copper Interconnect Technology for RF and Microwave Applications", Technical Digest of the 1999 International Electron Devices Meeting, S. 569-572 und in R. Tang und Mitautoren: "A Low-Cost Modular SiGe BiCMOS Technology and Analog Passives for High-Performance RF and Wide-Band Applications", Proceedings of the 2000 Bipolar/BiCMOS Circuits and Technology Meeting, S. 102-105 beschrieben. Charakteristisch für diese Technologien ist, dass wesentliche Verfahrensschritte zur Integration der HBT in den ursprünglichen CMOS-Prozess und zur Herstellung der HBT selbst, wie die Abscheidung von verschiedenen Schutzschichten, der SiGe-Basisschicht und der Emitterschicht, nach Herstellung der CMOS-Wannen, der Gate-Oxydation, der Gate-Strukturierung und (im ersten Zitat) der Dotierung und Ausheilung der MOS-Transistoren mit n-Kanal erfolgen. Diese spezielle Verfahrensweise zur Herstellung von Bipolartransistoren innerhalb einer BiCMOS-Technologie hat den Nachteil, dass eine Beeinflussung der vertikalen und lateralen Dotierungsprofile der CMOS-Transistoren durch HBT-Verfahrenschritte, vor allem durch deren gegebenes thermisches Budget, nicht völlig ausgeschlossen werden kann. Das kann zur Folge haben, dass sich die ursprünglichen CMOS-Transistorparameter im BiCMOS-Prozess nicht exakt reproduzieren lassen.

Dieser Nachteil könnte theoretisch vermieden werden, wenn alle technologischen Verfahrensschritte, die zur Integration und Herstellung der Bipolartransistoren angewandt werden, vor der Herstellung der Wannen und der Gate-Isolatorschicht für die MOS-Transistoren durchgeführt würden. Allerdings wirken bei dieser Verfahrensweise dann die CMOS-Verfahrensschritte auf die Bipolarstrukturen ein, was die Realisierung der für sehr gute Hochfrequenzeigenschaften notwendigen steilen Dotierungsprofile, insbesondere in der Basis der Bipolartransistoren, außerordentlich erschwert. Das gilt insbesondere für SiGe-HBT, wo eine Verbreiterung des Basis-Dotierungsprofiles (Bor) über die Ränder der SiGe-Schicht zur Bildung von parasitären Leitungsbandbarrieren führt, die das Erreichen sehr guter Hochfrequenzeigenschaften unmöglich machen. Hinsichtlich ihrer Wirkung auf die Dotierungsprofile der Bipolartransistoren besonders kritische CMOS-Verfahrensschritte sind die Gate-Oxidation und wenn angewandt, die Reoxidation der Polysilizium-Gates, beide allein auf Grund des dabei gewöhnlich angewandten thermischen Budgets. Bei Einwirkung dieser Schritte auf ungeschützte einkristalline Gebiete der Bipolarstrukturen wirkt zusätzlich der sogenannte OED-Effekt (OED - Oxydation Enhanced Diffusion). Ein weiterer kritischer CMOS-Verfahrensschritt ist die Ausheilung des Implantes, der für die Dotierung der Gates und Source-Drain-Gebiete der MOS-Transistoren mit n-Kanal angewandt wird. Insbesondere bei Verwendung von Arsen als Dotierelement muss, um eine Gate-Verarmung zu vermeiden, üblicherweise ein thermisches Budget angewandt werden, das das Basis-Dotierungsprofil von Bipolartransistoren stark verbreitern und im Falle von SiGe-HBTs über die Ränder der SiGe-Schicht verschieben kann.

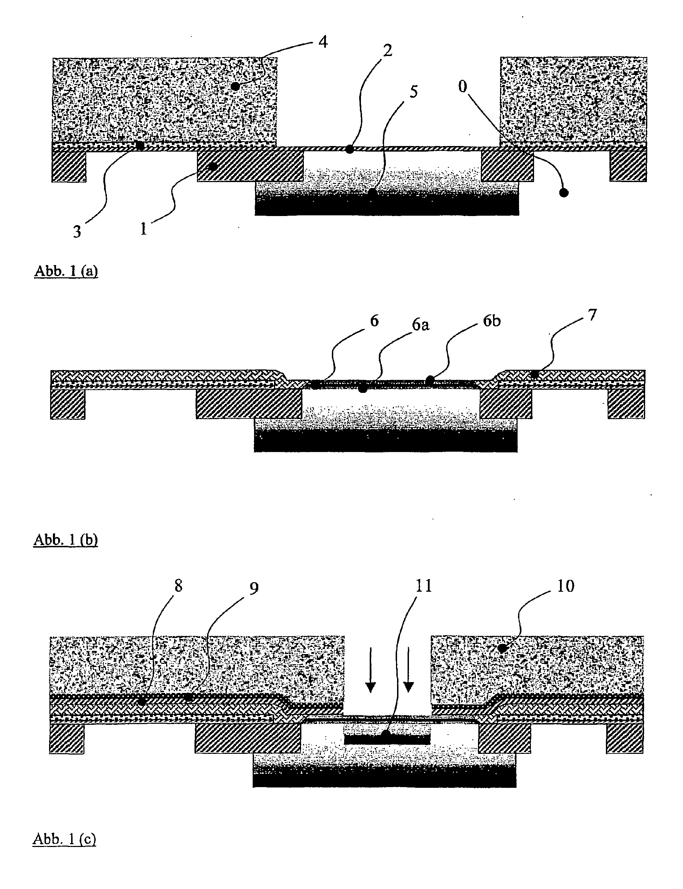

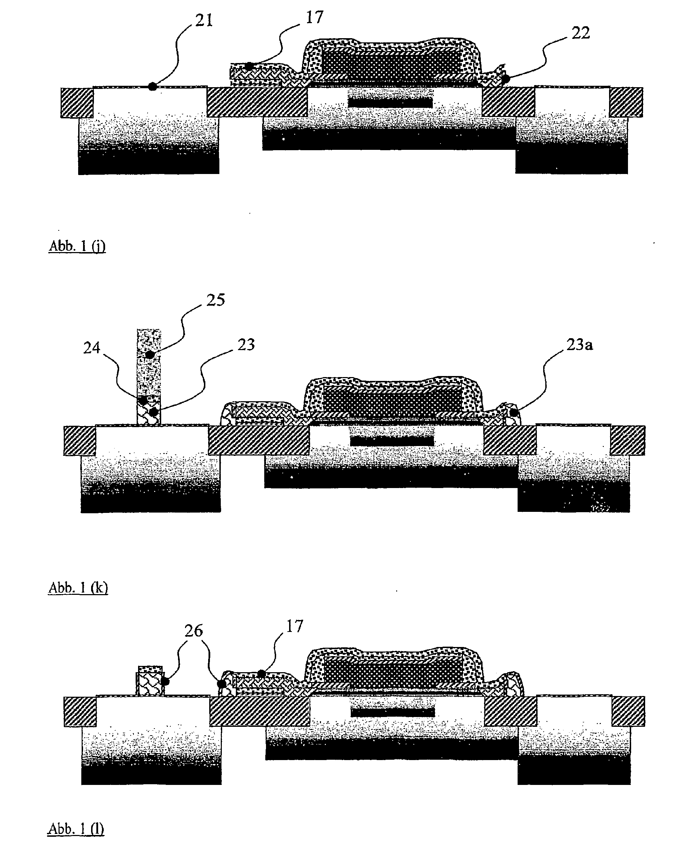

Aufgabe der Erfindung ist es deshalb, die beschriebenen Nachteile des Standes der Technik zu beseitigen und ein Verfahren zur Herstellung von schnellen vertikalen npn-Bipolartransistoren und komplementären MOS-Transistoren auf einem Chip vorzuschlagen und darüber hinaus jede Beeinflussung der vertikalen und lateralen Dotierungsprofile der CMOS-Transistoren durch die Verfahrensschritte, die für die Herstellung der Bipolartransistoren angewandt werden, zu vermeiden. Erfindungsgemäß wird diese Aufgabe dadurch gelöst, dass sämtliche technologische Verfahrensschritte zur Herstellung der Vertikalstruktur von Kollektor, Basis und Emitter im aktiven Gebiet der npn-Bipolartransistoren sowie zur lateralen Strukturierung der Kollektor-, Basis- und Emittergebiete vor der Herstellung der Wannen und der Gate-Isolatorschicht für die MOS-Transistoren ausgeführt werden. Die technologischen Verfahrensschritte zur Herstellung der Vertikalstruktur von Kollektor, Basis und Emitter im aktiven Gebiet der npn-Bipolartransistoren sowie zur lateralen Strukturierung der Kollektor-, Basis- und Emittergebiete werden vor der Herstellung der Wannen und Gate-Isolatorschicht für die MOS-Transistoren durchgeführt. Die fertiggestellten Strukturen der npn-Bipolartransistoren werden erfindungsgemäß vor der Herstellung der Gate-Isolatorschicht für die MOS-Transistoren mit einer Schutzschicht versehen, die während der Ausführung technologischer Verfahrensschritte zur Herstellung der MOS-Transistoren eine Umwandlung von Silizium zu Siliziumoxid innerhalb der fertiggestellten Strukturen der npn-Bipolartransistoren verhindert. Ein Relief wird zwischen den strukturierten Emitter und Basisgebieten der npn-Bipolartransistoren vor der Herstellung der Gate-Isolatorschicht für die MOS-Transistoren soweit verrundet, dass die Bildung von Spacern an diesem Relief während der Strukturierung der Gates der MOS-Transistoren vermieden wird. Für die Ausbildung der Vertikalstruktur von Kollektor, Basis und Emitter im aktiven Gebiet der npn-Bipolartransistoren und die laterale Strukturierung der Kollektor-, Basis- und Emittergebiete werden nicht mehr als 4 lithographische Schritte angewandt. Das Dotierungsprofil für die Basis der Bipolarstrukturen in vertikaler Richtung wird mit einem C-Atomprofil umhüllt, das eine Konzentration im Bereich 1x10¹⁹ bis 1x10²⁰ cm⁻³ aufweist. Trotz Einwirkung der CMOS-Verfahrensschritte auf die Bipolarstrukturen, die in der BiCMOS-Technologie hergestellten Bipolartransistoren ein vertikales Dotierungsprofil aufweisen, erlaubt das erfindungsgemäße Verfahren, ein Produkt von Kollektor-Emitter-Durchbruchsspannung (BVceo) und Transitfrequenz (fr) von mindestens 150 VGHz zu erreichen. Im Folgenden wird anhand eines Beispiels, illustriert durch die Abbildungen 1(a) bis 1(p), die erfindungsgemäße Herstellung von Einzel-Polysilizium npn SiGe-HBT in einer BiCMOS-Technologie dargelegt.

Die dabei vorgestellte Verfahrensweise kann ebenso gut auf Doppel-Polysilizium npn SiGe-HBT sowie auf npn Si-Homo-Bipolartransistoren, deren Basis durch Implantation oder Epitaxie hergestellt wird, übertragen werden.

Abb. 1(a) zeigt die Ausgangsstruktur. Isolationsgebiete 1, bestehend aus SiO₂, wurden mit in der Halbleitertechnologie üblichen Methoden in eine Si-Scheibe 0 eingebracht. Die Scheibe ist mit einer weiteren SiO₂-Schicht 2 und einer Schicht 3, bestehend aus Si₃N₄, ganzflächig bedeckt. Eine erste Maske aus Fotolack 4 wurde mit den in der Halbleitertechnologie gebräuchlichen Methoden hergestellt. In den von Fotolack befreiten Gebieten wurde die Nitridschicht vorzugsweise trockenchemisch herausgeätzt und anschließend durch Implantation mit Ionen ein n-leitendes Gebiet 5 hergestellt. Die bei dieser Implantation erzeugten Schäden werden nach Entfernung der Lackmaske und geeigneter Reinigung vorzugsweise mittels eines RTA-Schrittes (RTA - Rapid Thermal Annealing) ausgeheilt. Anschließend wird die unterliegende SiO₂-Schicht mittels einer geeigneten flusssäurehaltigen Lösung entfernt, wobei die vorher strukturierte Nitridschicht als Maske dient.

Nach Anwendung geeigneter Reinigungsprozeduren erfolgt dann die Herstellung eines einkristallinen Schichtstapels, bestehend aus einer Si-Pufferschicht 6a, der mit Bor-Atomen dotierten SiGe-Basisschicht 6 und der Si-Deckschicht 6b (Abb. 1(b)). Durch geeignete Gestaltung des Abscheideprozesses wird erreicht, dass während des epitaktischen Wachsens der Schichten 6a, 6 und 6b gleichzeitig eine polykristalline Si/SiGe/Si-Schicht 7 auf den mit SiO₂ oder Si₃N₄ bedeckten Gebieten entsteht. Wesentlich für die erfindungsgemäße Herstellung der SiGe-HBT ist, dass beim Abscheideprozess der SiGe-Schicht das Dotierungsprofil für die Basis der Bipolarstrukturen in vertikaler Richtung mit einem C-Atomprofil umhüllt wird, das eine Konzentration im Bereich 1x10¹⁹ - 1x10²⁰ cm⁻³ aufweist. Diese Maßnahme verhindert, dass das später für die Bildung der CMOS-Strukturen angewandte thermische Budget zu einer Verbreiterung des Basis-Dotierungsprofiles über die Ränder der SiGe-Schicht und damit zur Bildung von parasitären Leitungsbandbarrieren führt, die das Erreichen der angestrebten Hochfrequenzeigenschaften unmöglich machen würden.

Abb. 1(c) zeigt die Herstellung der Emitterfenster der HBT mit der Fotolackmaske 10. Diese Maske wird benutzt, um vorzugsweise mittels trockenchemischen Ätzens in den lackfreien Gebieten die aus amorphem oder polykristallinem Si bestehende Schicht 9 und einen Teil der SiO₂-Schicht 8 zu entfernen und mittels Ionenimplantation lokal ein n-leitendes Gebiet 11 zu erzeugen. Nach Entfernen der Lackmaske wird im geätzten Fenster mittels flusssäurehaltiger Lösung der Rest der SiO₂-Schicht 8 entfernt und eine Si-Schicht 12 abgeschieden. Diese Schicht wird während der Abscheidung vorzugsweise mit As dotiert, wobei eine As-Konzentration von mindestens 10²⁰ cm⁻³ eingestellt wird.

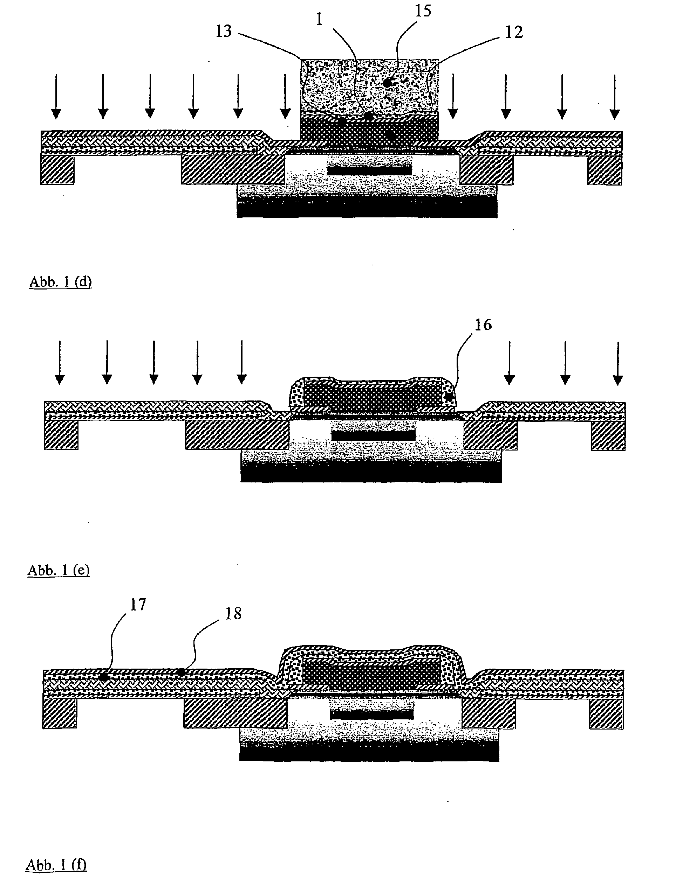

Abb. 1(d) zeigt die Strukturierung der Schichten 9 und 12 sowie der Hilfsschichten 13, bestehend aus SiO₂, und 14, vorzugsweise bestehend aus Si-reichem Siliziumnitrid, die mittels Fotolackmaske 15 und trockenchemischem Ätzen in einer definierten Distanz zum Emitterfenster erfolgt. Nach dem Ätzen dient Maske 12 noch dem lokalen Einbringen eines B- oder BF₂-Implantes zur Dotierung der äußeren Basisgebiete der HBT.

Nach Entfernen der Lackmaske wird eine Si₃N₄-Schicht abgeschieden und ohne Verwendung einer Lackmaske mittels eines stark anisotrop wirkenden Ätzschrittes wieder entfernt, wobei an den zuvor erzeugten Kanten des Schichtstapels 9, 12, 13, 14 der Si₃N₄-Spacer 16 (Abb. 1(e)) gebildet wird, der diese Kanten verrundet. Durch diese Verrundung soll die Bildung von Spacern an diesen Kanten beim späteren Strukturieren der CMOS-Gates verhindert werden. Nach Bildung der Si₃N₄-Spacer 16 wird Schicht 8 mittels flusssäurehaltiger Lösung entfernt und es erfolgt optional wieder eine Implantation mit B- oder BF₂-lonen, die zur weiteren Erhöhung des Dotierungsniveaus der äußeren Basisgebiete der HBT dient.

Auf die entstandene Struktur werden dann eine Si₃N₄-Schicht 17 und eine SiO₂-Schicht 18 abgeschieden (Abb. 1(f)).

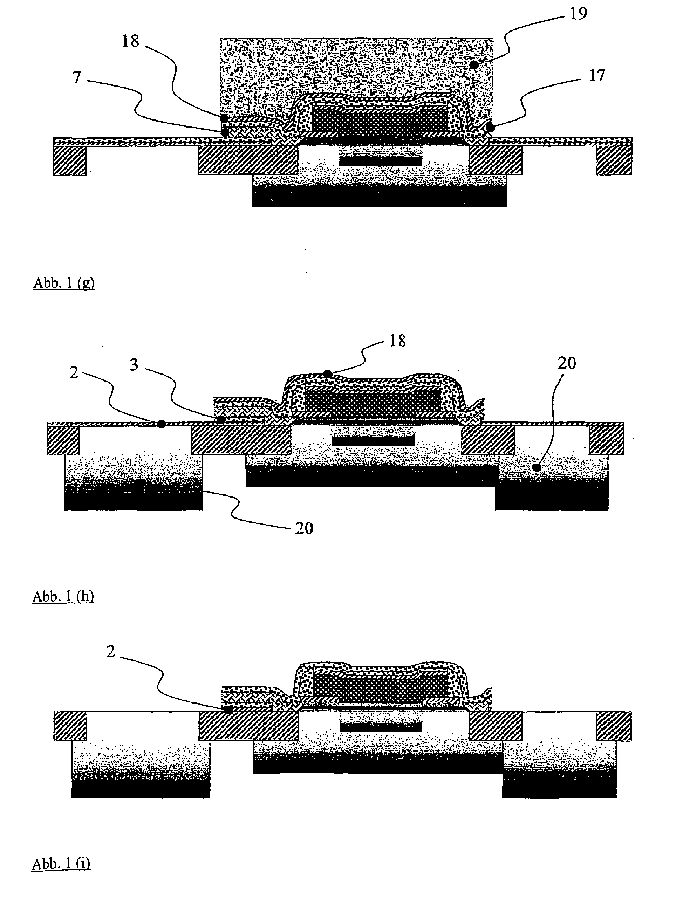

Die folgende Lackmaske 19 definiert den Außenrand der äußeren Basisgebiete der HBT. Mit dieser Lackmaske werden die Schichten 18, 17 und 7 vorzugsweise mittels trockenchemischen Ätzens von allen Gebieten entfernt, in denen später die CMOS-Transistoren hergestellt werden (Abb. 1(g)).

Nach Entfernung der Lackmaske 19 wird dann die Si₃N₄-Schicht 3 vorzugsweise mittels Phosphorsäure entfernt, wobei auf Grund der bekannt hohen Selektivität der Ätzraten kein Ätzangriff auf die unterliegende SiO₂-Schicht 2 erfolgt (Abb. 1(h)). In diesem Stadium des BiCMOS-Prozesses beginnt die Herstellung der CMOS-Transistoren. Durch Anwendung von verschiedenen Lackmasken, Implantations- und Ausheilschritten erfolgt zunächst die Herstellung der n- und p-Wannen für die MOS-Transistoren mit p- bzw. n-Kanal.

Abb. 1(h) zeigt als Beispiel die realisierte n-Wanne 20 eines MOS-Transistors mit p-Kanal. Abb. 1(h) zeigt auch, dass durch geeignete Lackmaskengestaltung die n-Wannen, überlappend zum n-leitenden Gebiet 5, in die Gebiete eingebracht werden können, auf denen später die Kontaktierung der HBT-Kollektoren erfolgt. Auf diese Weise kann erreicht werden, dass nicht mehr als 4 lithografische Schritte (Lackmasken 4, 10, 15 und 19) für die Ausbildung der HBT-Struktur benötigt werden.

Im Anschluss wird die SiO₂-Schicht 2 über den Wannengebieten der CMOS-Transistoren und gleichzeitig die SiO₂-Schicht 18 über den HBT-Strukturen mittels flusssäurehaltiger Lösung entfernt (Abb. 1(i)).

Nach Anwendung von einer der üblichen Reinigungsprozeduren erfolgt dann die Gateoxidation, wobei über den Wannengebieten der CMOS-Transistoren die dünne SiO₂-Schicht 21 und an den freiliegenden Kanten der polykristallinen SiGe/Si-Schicht 7 die Oxidschicht 22 entstehen (Abb. 1(j)). Wesentlich für die erfindungsgemäße Herstellung der SiGe-HBT ist, dass die Abdeckung der HBT-Strukturen mit der Si₃N₄-Schicht 17 eine Umwandlung von Silizium zu Siliziumoxid innerhalb dieser Strukturen verhindert.

Abb. 1(k) illustriert die Herstellung der Gates der CMOS-Transistoren, bestehend aus einer vorzugsweise amorphen Si-Schicht 23, unter Benutzung einer Si-reichen Nitridschicht 24 und der Lackmaske 25. Beim Trockenätzen der Schichten 24 und 23 bilden sich an den äußeren Kanten der HBT-Struktur die Spacer 23a, die keinerlei negativen Einfluss auf die Funktion oder Parameter der HBT haben.

Eine unerwünschte Spacerbildung am inneren Relief der HBT-Struktur wird durch dessen Verrundung, wie im Zusammenhang mit Abb. 1(e) beschrieben, verhindert. Nach Entfernung der Lackmaske 25 erfolgt die Reoxidation der Gates, wobei sich an deren Seitenwänden die Oxidschicht 26 bildet (Abb. 1(1)).

Wie im Falle der Gateoxidation verhindert die Si₃N₄-Schicht 17 wieder eine Umwandlung von Silizium zu Siliziumoxid innerhalb der HBT-Strukturen. Nicht illustriert ist hier die Herstellung sogenannter LDD-Gebiete oder die Anwendung sogenannter Pocket-Implantationen, wie sie in modernen CMOS-Technologien üblicherweise genutzt werden. Die dafür notwendigen technologischen Schritte können ohne Probleme auch in den hier beschriebenen BiCMOS-Prozess eingeführt werden.

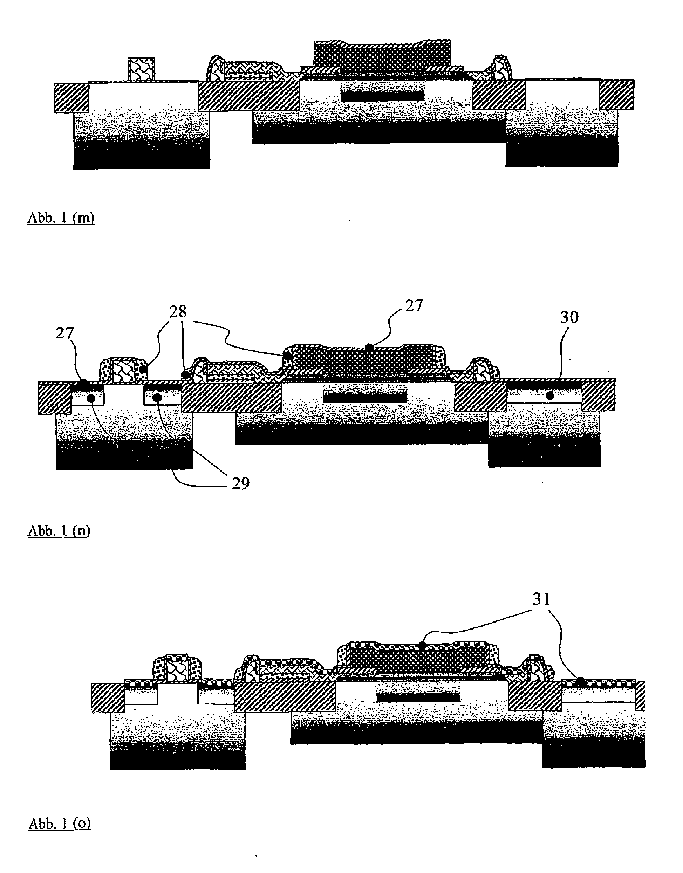

Durch einen anschließenden Ätzschritt in Phosphorsäure wird nun über den CMOS-Gates die Nitridschicht 24 und über den HBT-Strukturen die Nitridschicht 17 entfernt (Abb. 1(m)).

Abb. 1(n) illustriert die anschließende Herstellung der Gate-Nitrid-Spacer 28 auf einer Oxidunterlage 27, sowie (am Beispiel des MOS-Transistors mit p-Kanal gezeigt) die Herstellung der hochdotierten Source- und Draingebiete 29 der CMOS-Transistoren. Durch geeignete Gestaltung der Lackmaske für die Implantation der Source- und Draingebiete der MOS-Transistoren mit n-Kanal kann diese Implantation auch zur Herstellung von hochdotierten, n-leitenden Gebieten 30 im Kontaktbereich der HBT-Kollektoren genutzt werden. Nach Entfernung der (nicht gezeigten) Lackmasken für die Source/Drain-Implantationen und üblicherweise mittels RTA ausgeführten Ausheilschritten erfolgt dann die Entfernung der Oxidschicht 27 mittels flusssäurehaltiger Lösung. Im Anschluss daran wird mit den in der Halbleitertechnologie gebräuchlichen Methoden auf allen nicht mit einer Isolatorschicht bedeckten Si-Gebieten eine Kontaktsilizid-Schicht 31 gebildet (Abb. 1(o)) und für eine Kontaktierung, Verdrahtung und Passivierung der Transistoren gesorgt.

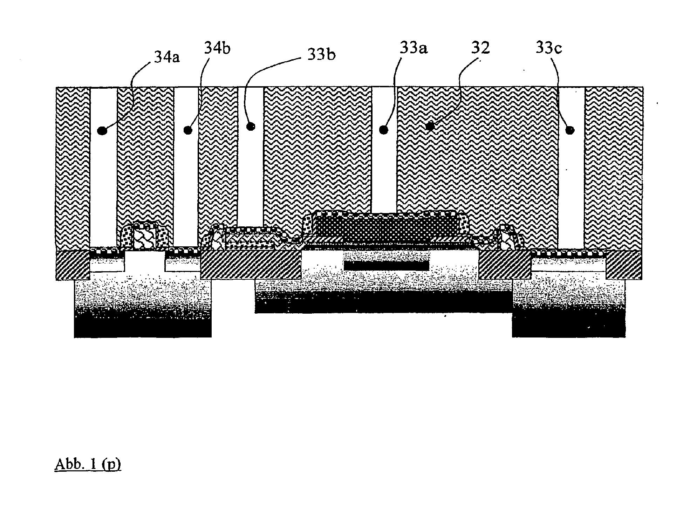

Abb. 1(p) illustriert noch die Herstellung der Kontaktlöcher in der Isolationsschicht 32 für den HBT-Emitter 33a, die HBT-Basis 33b und den HBT-Kollektor 33c, sowie für Source 34a und Drain 34b der CMOS-Transistoren.

In der vorliegenden Beschreibung wurde anhand eines konkreten Ausführungsbeispiels das erfindungsgemäße Verfahren zur Herstellung von schnellen vertikalen npn-Bipolartransistoren und komplementären MOS-Transistoren auf einem Chip dargestellt. Es sei aber vermerkt, dass die vorliegende Erfindung nicht auf die Einzelheiten der Beschreibung in dem Ausführungsbeispiel beschrankt ist, da im Rahmen der Ansprüche Änderungen und Abwandlungen beansprucht werden.

## Patentansprüche

1. Verfahren zur Herstellung von schnellen vertikalen npn-Bipolartransistoren und komplementären MOS-Transistoren auf einem Chip charakterisiert durch die Ausführung sämtlicher technologischer Verfahrenss.chritte zur Herstellung der Vertikalstruktur von Kollektor, Basis und Emittel im aktiven Gebiet der npn-Bipolartransistoren sowie zur lateralen Strukturierung der Kollektor-; Basis- und Emittergebiete vor der Herstellung der Wanner (20) und der Gate-Isolatorschicht (21) für die MOS-Transistoren, wobei die fertiggestellten Strukturen der npn-Bipolartransistoren vor der Herstellung der Gate-Isolatorschicht (21) für die MOS-Transistoren mit einer Schutzschicht (17) versehen werden, die wahrend der Ausführung technologischer Verfahrensschritte zur Herstellung der MOS-Transistoren eine Umwandlung von Silizium zu Siliziumoxid innerhalb der fertiggestellten Strukturen der npn-Bi-polartransistoren verhindert.

2. Verfahren nach Anspruch 1, wobei npn-Bipolartransistoren mit einem Produkt von Kollektor-Emitter-Durchbruchsspannung (BV_{CEO}) und Transitfrequenz (f_{T}) von mindestens 150 VGHz hergestellt werden.

3. Verfahren nach einem oder mehreren der vorangegangenen Ansprüche, wobei ein Relief zwischen den strukturierten Emitter- und Basisgebieten der npn-Bipolartransistoren vor der Herstellung der Gate-Isolatorschicht (21) für die MOS-Transistoren soweit verrundet wird, dass die Bildung von Spacern an diesem Relief während der Strukturierung der Gates der MOS-Transistoren vermieden wird.

4. Verfahren nach einem oder mehreren der vorangegangenen Ansprüche, wobei für die Ausbildung der Vertikalstruktur von Kollektor, Basis und Emitter im aktiven Gebiet der npn-Bipolartransistoren und die laterale Strukturierung der Kollektor-, Basis- und Emittergebiete nicht mehr als 4 lithographische Schritte angewandt werden.

5. Verfahren nach einem oder mehreren der vorangegangenen Ansprüche, wobei das Dotierungsprofil für die Basis der Bipolarstrukturen in vertikaler Richtung mit einem C-Atomprofil umhüllt wird, das eine Konzentration im Bereich 1 x 10¹⁹ bis 1 x 10²⁰ cm⁻³ aufweist.

## Claims

1. Process for producing fast vertical npn bipolar transistors and complementary MOS transistors on a chip, **characterised by** the implementation of all the technological process steps for producing the vertical structure of collector, base and emitter in the active region of the npn bipolar transistors and for the lateral structuring of the collector, base and emitter regions before the production of the wells (20) and gate insulation layer (21) for the MOS transistors, wherein the finished structures of the npn-bipolar transistors are provided, before the production of the gate insulation layer (21) for the MOS transistors, with a protective layer (17) which prevents the conversion of silicon into silicon oxide within the finished structures of the npn-bipolar transistors during the implementation of the technological process steps for producing the MOS transistors.

2. Process according to claim 1, wherein npn bipolar transistors are produced with a product of collector-emitter-breakdown voltage (BVcEo) and transit frequency (fr) of at least 150 VGHz.

3. Process according to one of or more of the preceding claims, wherein a relief between the structured emitter and base regions of the npn bipolar transistors is rounded off, before the production of the gate insulation layer (21) for the MOS transistors, to such an extent that the formation of spacers on this relief is avoided during the structuring of the gates of the MOS transistors.

4. Process according to one of or more of the preceding claims, wherein not more than 4 lithographic steps are used for the formation of the vertical structure of collector, base and emitter in the active region of the npn bipolar transistors and the lateral structuring of the collector, base and emitter regions.

5. Process according to one or more of the preceding claims, wherein the doping profile for the base of the bipolar structures is enveloped, in the vertical direction, with a C-atom profile that has a concentration in the range from 1 x 10¹⁹ to 1 x 10²⁰ cm⁻³.

## Revendications

1. Procédé de fabrication de transistors bipolaires NPN verticaux rapides et de transistors MOS complémentaires sur une puce, **caractérisé par** l'exécution de toutes les étapes technologiques de procédé pour la fabrication de la structure verticale collecteur, base et émetteur, dans la zone active des transistors NPN bipolaires ainsi que pour la structuration latérale des zones de collecteur, base et émetteur avant la production des puits de transistor (20) et de la couche isolante de grille (21) pour les transistors MOS, les structures fabriquées des transistors bipolaires NPN étant pourvues d'une couche protectrice (17) avant la réalisation de la couche isolante de grille (21) pour les transistors MOS, ladite couche protectrice empêchant une transformation du silicium en oxyde de silicium à l'intérieur des structures fabriquées des transistors bipolaires NPN pendant l'exécution des phases technologiques de procédé pour la fabrication des transistors MOS.

2. Procédé selon la revendication 1, où des transistors bipolaires NPN sont réalisés avec un produit de la tension de claque inverse collecteur-émetteur (BV_{CEO}) et de la fréquence de transition (f_{T}) d'au moins 150 VGHz.

3. Procédé selon l'une ou plusieurs des revendications précédentes, où un relief entre les zones d'émetteur et de base des transistors bipolaires NPN est arrondi avant la réalisation de la couche isolante de grille (21) pour les transistors MOS, jusqu'à empêcher la formation de séparateurs sur ce relief pendant la structuration des grilles des transistors MOS.

4. Procédé selon l'une ou plusieurs des revendications précédentes, où pas plus de 4 étapes lithographiques sont appliquées pour la réalisation de la structure verticale collecteur, base et émetteur, dans la zone active des transistors NPN bipolaires et la structuration latérale des zones de collecteur, base et émetteur.

5. Procédé selon l'une ou plusieurs des revendications précédentes, où le profil de dopage pour la base des structures bipolaires en direction verticale est enrobé d'un profil C atomique avec une concentration comprise dans la plage de 1 × 10¹⁹ à 1 × 10²⁰ cm⁻³.
